# EUROPÄISCHE PATENTSCHRIFT

(11) **EP 2 828 969 B1**
(45) Veröffentlichungstag und Bekanntmachung des Hinweises auf die Patenterteilung: **16.03.2016**
(21) Anmeldenummer: 13713380.7
(22) Anmeldetag: 19.03.2013
(51) Int. Cl.: H02N 2/06, H01L 41/04

(54) **VERFAHREN ZUM BETRIEB EINES KAPAZITIVEN STELLGLIEDES**
METHOD FOR OPERATING A CAPACITIVE ACTUATOR
PROCÉDÉ POUR FAIRE FONCTIONNER UN ACTIONNEUR CAPACITIF

(30) Priorität: 22.03.2012 DE 102012204576
(43) Veröffentlichungstag der Anmeldung: 28.01.2015
(73) Patentinhaber: Continental Automotive GmbH, 30165 Hannover (DE)
(72) Erfinder: ETZLER, Dirk, Rochester Hills, MI 48309 (US); SCHROD, Walter, 93057 Regensburg (DE)
(86) Internationale Anmeldenummer: PCT/EP2013/055617
(87) Internationale Veröffentlichungsnummer: WO 2013/139757

(56) Entgegenhaltungen:
- DE-A1- 10 303 779
- DE-A1- 10 321 208

## Beschreibung

Bei modernen Verbrennungskraftmaschinen mit Kraftstoffeinspritzung sollten die verwendeten Kraftstoffinjektoren möglichst verzögerungsfrei ansprechbar sein. Dieser Anforderung werden kapazitive Stellglieder und hier insbesondere kapazitiv wirkende Piezo-Elemente gerecht. Solche kapazitiven Stellglieder stellen für die entsprechende Spannungsversorgungsschaltung eine starke kapazitive Last dar, die in einer sehr kurzen Zeitspanne auf eine vorgegebene Spannung aufgeladen und anschließend sehr schnell wieder entladen werden muss. Zudem muss die Ansteuerung und damit die Aufladung sehr exakt und reproduzierbar möglich sein, sodass auch für kleinste Kraftstoffmengen eine definierte Einspritzung realisiert werden kann. Zum Öffnen des entsprechenden Kraftstoffinjektors wird das kapazitive Stellglied auf eine bestimmte Ladung aufgeladen und zum Schließen wird das Stellglied wieder entladen.

Zur Ansteuerung von Piezo-Aktoren ist eine Vorrichtung zum Laden und Entladen gebräuchlich, wie sie in der EP 0 871 230 B1 beschrieben ist. Dort wird ein Kondensator aus einem Gleichspannungswandler, der die Batteriespannung des Fahrzeugs hochsetzt, aufgeladen. Über eine dem Kondensator parallel geschaltete Serienschaltung aus zwei Leistungsschaltelementen und über eine Drosselspule wird ein Piezo-Aktor aufgeladen oder entladen. Bei dieser Schaltung kann der Piezo-Aktor jedoch maximal auf den Wert der Spannung am Kondensator aufgeladen werden, sodass der Gleichspannungswandler entsprechend leistungsfähig ausgelegt werden muss, was kostspielig ist.

Alternativ hierzu gibt es Ansteuereinheiten für kapazitive Stellglieder, die, wie in der DE 199 52 950 A1 beschrieben, mit einem Transformator gebildet sind, bei denen in einer ersten Ansteuerphase Energie im Transformator gespeichert wird, die in einer zweiten Phase durch Abbau des magnetischen Feldes im Transformator auf das kapazitive Stellglied übertragen wird.

Diese als Sperrwandler oder Flyback-Konverter bezeichnete Anordnung wird als Aufwärtswandler betrieben, kann also deutlich höhere Spannungen an ihrem Ausgang zur Verfügung stellen, als am Eingang anliegen. Allerdings ist hierfür ein teurer Transformator erforderlich.

Eine weitere Alternative ist in der DE 103 28 623 A1 beschrieben, die eine Kombination aus einem Aufwärtswandler mit einem Sperrwandler darstellt, indem die ausgangsseitige Drosselspule eines Abwärtswandlers gemäß der EP 0 871 230 B1 mit einer eingangsseitigen Drosselspule induktiv schwach gekoppelt ist. Die dortige Konverterschaltung ist mit zu einer Halbbrücke verschalteten Leistungselementen gebildet, soll jedoch auch mit einer Vollbrücke betrieben werden können, wobei allerdings nicht ersichtlich ist, wie diese verschaltet werden soll.

Die DE 199 27 087 A1, die DE 101 55 388 A1 und die DE 102 15 630 A1 offenbaren Vorrichtungen zum Laden und Entladen von Piezo-Injektoren mit einem zwischen einem Eingangsanschluss der Vorrichtung und einem Bezugspotential angeordneten Kondensator, mit einer zu diesem parallel geschalteten ersten Serienschaltung eines ersten und eines zweiten Leistungsschaltelements und mit einer Spule, deren Anschluss mit dem Mittenabgriff der ersten Serienschaltung verbunden ist, wobei der zweite Anschluss der Spule über ein drittes Leistungsschaltelement mit dem Bezugspotential und über ein viertes Leistungsschaltelement mit einem Piezo-Injektor verbunden ist, wobei den Leistungsschaltelementen Dioden parallel geschaltet sind, derart, dass diese vom Eingangs- bzw. vom Ausgangsanschluss zum Bezugspotential in Sperrrichtung gepolt sind.

Zum Laden eines Piezo-Injektors werden das erste und das vierte Leistungsschaltelement angesteuert, wodurch ein Strom aus dem Kondensator durch die Spule in den Piezo-Injektor fließen kann, wodurch sich dieser auflädt. Allerdings kann auch hier, wie bei der EP 0 871 230 B1, der Piezo-Injektor maximal auf den Wert der Spannung am Kondensator aufgeladen werden.

Es ist daher die Aufgabe der Erfindung, ein Verfahren zum Betrieb eines kapazitiven Stellgliedes anzugeben, das die Nachteile des Standes der Technik vermeidet.

Es wird des Weiteren Bezug auf die Dokumente DE10303779 und DE10321208 genommen.

Die Aufgabe wird gemäß Anspruch 1 gelöst durch ein Verfahren zum Betrieb eines kapazitiven Stellgliedes, das mit einem Ausgangsanschluss einer Vorrichtung verbunden ist, die mit einem zwischen einem Eingangsanschluss der Vorrichtung und einem Bezugspotential angeordneten ersten Kondensator, mit einer zu diesem parallel geschalteten ersten Serienschaltung eines ersten und eines zweiten Leistungsschaltelements, mit einer ersten Spule, deren erster Anschluss mit dem Mittenabgriff der ersten Serienschaltung verbunden ist und deren zweiter Anschluss über ein drittes Leistungsschaltelement mit dem Bezugspotential und über ein viertes Leistungsschaltelement mit dem Ausgangsanschluss verbunden ist, gebildet ist, wobei den Leistungsschaltelementen Dioden parallel geschaltet sind, derart, dass sie vom Eingangs- bzw. vom Ausgangsanschluss zum Bezugspotential in Sperrrichtung gepolt sind. In erfindungsgemäßer Weise wird zum Laden des kapazitiven Stellgliedes zunächst von einer Steuerschaltung das erste und das dritte Leistungsschaltelement leitend gesteuert werden, sodass ein Strom vom ersten Kondensator über die erste Spule fließen kann, wodurch Energie in der Spule gespeichert wird, bei Erreichen eines vorgegebenen maximalen Stromwerts das zuvor eingeschaltete erste und dritte Leistungsschaltelement wieder ausgeschaltet wird, sodass sich die in der ersten Spule gespeicherte magnetische Energie durch einen Stromfluss über die Diode des zweiten Leistungsschaltelements und die Diode des vierten Leistungsschaltelements abbaut, wodurch sich das kapazitive Stellglied auf eine entsprechende Spannung auflädt, und durch gegebenenfalls wiederholtes Ein- und Ausschalten des ersten und dritten Leistungsschaltelements das kapazitive Stellglied auf eine vorgegebene Spannung aufgeladen wird.

In vorteilhafter Weiterbildung der Erfindung wird zum Entladen des kapazitiven Stellgliedes das zweite und das vierte Leistungsschaltelement von der Steuerschaltung eingeschaltet, sodass ein Strom vom kapazitiven Stellgliedes über die erste Spule zum Bezugspotential fließt.

Dieser erfindungsgemäße Betrieb der Vorrichtung mit als Vollbrücke verschalteten Leistungsschaltelementen, die vorzugsweise als Leistungstransistoren mit Inversdioden ausgebildet sind, erlaubt die Optimierung aller Schaltelemente auf die erforderliche maximale Spannung. Vollbrückenschaltungen minimieren die Bemessungsspannung für alle internen Schaltungsknoten und halten die internen Isolationsabstände so klein wie möglich.

Das erfindungsgemäße Verfahren kann bei einer Vorrichtung mit mehreren kapazitiven Stellgliedern in Parallelschaltung angewandt werden, wobei in vorteilhafter Weise in Serie zu jedem kapazitiven Stellglied ein Auswahlschaltelement angeordnet ist, sodass die Stellglieder gezielt angesteuert werden können.

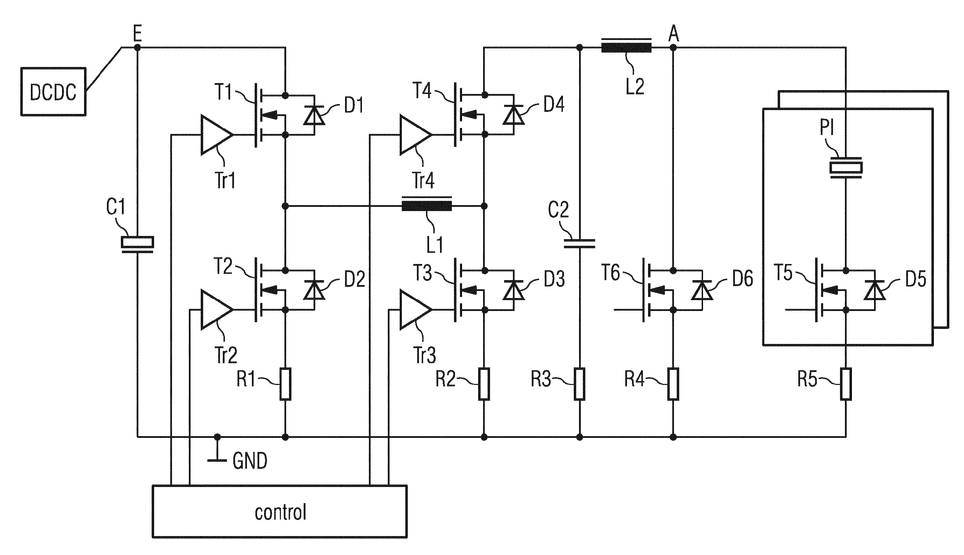

Die Erfindung wird nachfolgend anhand eines Ausführungsbeispiels mit Hilfe einer Figur näher erläutert. Dabei zeigt
- Figur 1: ein Prinzipschaltbild einer Vorrichtung zur Anwendung mit einem erfindungsgemäßen Verfahren.

Die Figur zeigt eine zum Laden und Entladen eines als Piezo-Injektor PI ausgebildeten kapazitiven Stellglieds ausgebildete Vorrichtung, bei der ein zwischen einem Eingangsanschluss E und einem Bezugspotential GND angeordneter erster Kondensator C1 mit einem Gleichspannungswandler DCDC verbunden ist und von diesem auf eine Eingangsspannung aufgeladen werden kann. Der Gleichspannungswandler DCDC erzeugt seinerseits aus beispielsweise der Batteriespannung eines Kraftfahrzeugs die entsprechend nötige Eingangsspannung der Vorrichtung.

Parallel zum ersten Kondensator C1 ist die Serienschaltung aus einem ersten als n-Kanal MOS Leistungstransistor T1 ausgebildeten Leistungsschaltelement, einem zweiten ebenfalls als n-Kanal MOS Transistor T2 ausgebildeten zweiten Leistungsschaltelement und einer als Shunt-Widerstand ausgebildeten ersten Strommessschaltung R1 verschaltet. Der erste Anschluss einer ersten Spule L1 ist mit dem Mittenabgriff der ersten Serienschaltung des ersten und zweiten Leistungsschaltelements T1, T2 verbunden, während der zweite Anschluss der ersten Spule L1 einerseits über ein drittes als n-Kanal MOS Leistungstransistor T3 ausgebildetes Leistungsschaltelement und über ein dazu in Serie geschaltetes, als Shunt-Widerstand ausgebildetes zweites Strommesselement R2 mit dem Bezugspotential GND verbunden ist. Der zweite Anschluss der ersten Spule L1 ist andererseits über ein ebenfalls als n-Kanal MOS Leistungstransistor T4 ausgebildetes viertes Leistungsschaltelement und über eine dazu in Serie geschaltete zweite Spule L2 mit dem Ausgangsanschluss A der Vorrichtung verbunden.

Der nicht mit der ersten Spule L1 verbundene Anschluss des vierten Leistungsschaltelements T4 ist über einen zweiter Kondensator C2 und ein als Shunt-Widerstand ausgebildetes drittes Strommesselement R3 mit dem Bezugspotential GND verbunden.
Der zweite Kondensator C2 und die zweite Spule L2 bilden ein Tiefpassfilter, um durch Schaltvorgänge der Leistungsschaltelemente T1 - T4 auftretende Strom- und Spannungsspitzen zu glätten.

Die Strommesselemente R1 bis R3 und auch weitere Strommesselemente können statt mit Shunt-Widerständen auch mit Stromspiegeln oder jedem anderen dem Fachmann geläufigen Mittel zur Stromerfassung gebildet werden. Sie sind in der Darstellung der Figur 1 zwar in allen zum Bezugspotential GND führenden Stromzweigen vorgesehen, können jedoch auch teilweise weggelassen werden, falls ein entsprechender Strom nicht von Interesse ist, oder in anderen Zweigen vorgesehen werden.

Insbesondere können in Ausgestaltungen der Vorrichtung das zweite und das dritte Leistungsschaltelement T2, T3 oder das dritte Leistungsschaltelement T3 und der zweite Kondensator C2 über nur jeweils ein gemeinsames Strommmesselement mit Bezugspotential GND verbunden sein, da durch die entsprechenden Strompfade bei bestimmungsgemäßem Betrieb nicht gleichzeitig ein Strom fließt.

Zwischen dem Ausgangsanschluss A der Vorrichtung und dem Bezugspotential GND ist in der dargestellten Schaltung der Figur 1 die Serienschaltung aus einem als Piezo-Injektor P1 ausgebildeten kapazitiven Stellglied und einem Auswahlleistungsschaltelement T5, das ebenfalls als n-Kanal MOS Leistungstransistor ausgebildet ist, sowie einem ebenfalls als Shunt-Widerstand ausgebildeten Strommmesselement R5 angeordnet.

Durch eine Umrandung der Serienschaltung aus dem Piezo-Injektor PI und dem Auswahlleistungsschaltelement T5 sowie einer dahinter dargestellten Umrandung ist angedeutet, dass mehrere solcher Piezo-Injektoren parallel zu dem dargestellten mit der Vorrichtung verbunden werden können und durch entsprechende Ansteuerung der zugehörigen Auswahlschalter T5 einer von ihnen ausgewählt werden kann. Bei mehreren parallel geschalteten Piezo-Injektoren PI kann jeder in Serie geschaltet einen Shunt-Widerstand aufweisen oder aber es sind alle Piezo-Injektoren mit dem dargestellten Shunt-Widerstand R5 verbunden. Dies ist möglich, da üblicherweise zu einer Zeit nur ein Piezo-Injektor ausgewählt ist.

Zwischen dem Ausgangsanschluss A der Vorrichtung und dem Bezugspotential ist ein sechstes Leistungsschaltelement T6 in Serie mit einem als Shunt-Widerstand ausgebildeten vierten Strommesselement R4 verschaltet. Mittels dieses sechsten Leistungsschaltelements T6 kann der oder die Piezo-Injektor/en gegebenenfalls schnell entladen werden.

Die Shunt-Widerstände R1 - R3 dienen zur Detektion des durch den jeweiligen Stromzweig fließenden Stromes, um die daran abfallende Spannung zur Regelung der Spannung am Piezo-Injektor in einer Steuerschaltung Control verwenden zu können. Die Steuerschaltung Control steuert hierzu über entsprechende Leitungen und Treiberschaltungen TR1 - TR4 die Steuereingänge der Leistungsschaltelemente T1 - T4 in bekannter Weise an. Die Verbindungsleitungen von entsprechenden Abgriffen der Shunt-Widerstände R1 bis R5 zur Steuerschaltung Control sind aus Übersichtlichkeitsgründen weggelassen.

Den Leistungsschaltelementen T1 - T6 sind jeweils eine Diode D1 - D6 parallel geschaltet und zwar in der Weise, dass sie zwischen dem Eingangsanschluss E und Bezugspotential GND bzw. zwischen dem Ausgangsanschluss A und Bezugspotential GND in Sperrrichtung gepolt verschaltet sind. Bei Verwendung der dargestellten n-Kanal MOS Leistungstransistoren sind diese Dioden D1 - D6 als intrinsische Dioden technologiebedingt vorhanden.

Zum erfindungsgemäßen Laden eines Piezo-Injektors PI werden zunächst von der Steuerschaltung Control der erste und der dritte n-Kanal MOS Leistungstransistor T1, T3 leitend gesteuert, sodass ein Strom vom ersten Kondensator C1 über die erste Spule L1 fließen kann, wodurch Energie in der Spule L1 gespeichert wird. Der Strom durch die erste Spule L1 steigt üblicherweise linear an, wobei bei Erreichen eines vorgegebenen maximalen Stromwerts, der durch den ersten Shunt-Widerstand R1 ermittelt wird, die zuvor eingeschalteten Leistungstransistoren T1, T3 wieder ausgeschaltet werden. Die in der ersten Spule L1 gespeicherte magnetische Energie baut sich durch einen Stromfluss über die Diode D2 des zweiten Leistungstransistors T2 und die Diode D4 des vierten Leistungstransistors T4 ab, der geglättet durch die Filterschaltung C2, L2 in den durch Ansteuerung des fünften Leistungstransistors T5 ausgewählten Piezo-Injektor PI fließt und diesen auf eine entsprechende Spannung auflädt. Durch wiederholtes Ein- und Ausschalten des ersten und dritten Leistungstransistors T1, T3 kann durch die Anzahl und Dauer der Einschaltvorgänge entsprechend der Messung der Spannung am Piezo-Injektor PI durch die Steuerschaltung Control der Piezo-Injektor auf eine vorgegebene Spannung aufgeladen werden.

Zum Entladen wird in entsprechender Weise der zweite und der vierte Leistungstransistor T2, T4 von der Steuerschaltung Control eingeschaltet, sodass nunmehr ein Strom vom Piezo-Injektor PI über die zweite Spule L2 und die erste Spule L1 zum Bezugspotential GND fließen kann. Nach dem Abschalten des zweiten und vierten Leistungstransistors T2, T4 wird die in der ersten Spule L1 gespeicherte magnetische Energie über die intrinsischen Dioden D1, D3 des ersten und dritten Leistungstransistors T1, T3 zurück in den ersten Kondensator C1 gespeichert.

Da beim Entladen des Piezo-Injektors PI auch ein Strom durch den zweiten (Filter-)Kondensator C2 zum Bezugspotential GND fließt, ist das dritte Strommesselement R3 vorgesehen, um aus der Summe der Ströme durch das zweite Leistungsschaltelement T2 und über den zweiten Kondensator C2 die genaue, dem Piezo-Injektor PI entnommene Ladung ermitteln zu können.

Die erfindungsgemäße Vorrichtung kann im kontinuierlichen, im diskontinuierlichen oder auch im (bevorzugten) Resonanzmodus betrieben werden. Sie erlaubt einen besonders vorteilhaften Betrieb, wenn die vom Gleichspannungswandler DCDC zur Verfügung gestellte Spannung am Eingang E der Vorrichtung ungefähr der am Ausgang A der Vorrichtung zur Versorgung des Piezo-Injektors PI benötigen Spannung entspricht.

## Patentansprüche

1. Verfahren zum Betrieb eines kapazitiven Stellgliedes (PI), das mit einem Ausgangsanschluss (A) einer Vorrichtung verbunden ist, die mit einem zwischen einem Eingangsanschluss (E) der Vorrichtung und einem Bezugspotential (GND) angeordneten ersten Kondensator (C1), mit einer zu diesem parallel geschalteten ersten Serienschaltung eines ersten und eines zweiten Leistungsschaltelements (T1, T2), mit einer ersten Spule (L1), deren erster Anschluss mit dem Mittenabgriff der ersten Serienschaltung verbunden ist und deren zweiter Anschluss über ein drittes Leistungsschaltelement (T3) mit dem Bezugspotential (GND) und über ein viertes Leistungsschaltelement (T4) mit dem Ausgangsanschluss (A) verbunden ist, gebildet ist,
wobei den Leistungsschaltelementen (T1 - T4) Dioden (D1 - D4) parallel geschaltet sind, derart, dass sie vom Eingangs- (E) bzw. vom Ausgangsanschluss (A) zum Bezugspotential (GND) in Sperrrichtung gepolt sind,
**dadurch gekennzeichnet, dass**
zum Laden des kapazitiven Stellgliedes (PI) zunächst von einer Steuerschaltung (Control) das erste und das dritte Leistungsschaltelement (T1, T3) leitend gesteuert werden, sodass ein Strom vom ersten Kondensator (C1) über die erste Spule (L1) fließen kann, wodurch Energie in der Spule (L1) gespeichert wird, bei Erreichen eines vorgegebenen maximalen Stromwerts das zuvor eingeschaltete erste und dritte Leistungsschaltelement (T1, T3) wieder ausgeschaltet wird, sodass sich die in der ersten Spule (L1) gespeicherte magnetische Energie durch einen Stromfluss über die Diode (D2) des zweiten Leistungsschaltelements (T2) und die Diode (D4) des vierten Leistungsschaltelements (T4) abbaut, wodurch sich das kapazitive Stellglied (PI) auf eine entsprechende Spannung auflädt, und
durch gegebenenfalls wiederholtes Ein- und Ausschalten des ersten und dritten Leistungsschaltelements (T1, T3) das kapazitive Stellglied (PI) auf eine vorgegebene Spannung aufgeladen wird.

2. Verfahren nach Anspruch 1, **dadurch gekennzeichnet, dass** zum Entladen des kapazitiven Stellgliedes (PI) das zweite und das vierte Leistungsschaltelement (T2, T4) von der Steuerschaltung (Control) eingeschaltet werden, sodass ein Strom vom kapazitiven Stellgliedes (PI) über die erste Spule (L1) zum Bezugspotential (GND) fließt.

## Claims

1. Method for operating a capacitive actuator (PI), which is connected to an output connection (A) of an apparatus, which is formed by a first capacitor (C1), which is arranged between an input connection (E) of the apparatus and a reference potential (GND), by a first series circuit comprising a first and a second power switching element (T1, T2), which series circuit is connected in parallel with said capacitor, by a first coil (L1), whose first connection is connected to the center tap of the first series circuit and whose second connection is connected to the reference potential (GND) via a third power switching element (T3) and to the output connection (A) via a fourth power switching element (T4), wherein diodes (D1-D4) are connected in parallel with the power switching elements (T1-T4) in such a way that they are polarized in the reverse direction from the input connection (E) or from the output connection (A) to the reference potential (GND),
**characterized in that**
in order to charge the capacitive actuator (PI), first the first and third power switching elements (T1, T3) are turned on by a control circuit (Control) so that a current can flow from the first capacitor (C1) via the first coil (L1), as a result of which energy is stored in the coil (L1), and when a preset maximum current value is reached, the previously switched-on first and third power switching elements (T1, T3) are switched off again so that the magnetic energy stored in the first coil (L1) decays as a result of a current flow via the diode (D2) of the second power switching element (T2) and the diode (D4) of the fourth power switching element (T4), as a result of which the capacitive actuator (PI) charges to a corresponding voltage, and by possibly repeated switching-on and switching-off of the first and third power switching elements (T1, T3), the capacitive actuator (PI) is charged to a preset voltage.

2. Method according to Claim 1, **characterized in that,** in order to discharge the capacitive actuator (PI), the second and fourth power switching elements (T2, T4) are switched on by the control circuit (Control) so that a current flows from the capacitive actuator (PI) via the first coil (L1) to the reference potential (GND).

## Revendications

1. Procédé de mise en fonctionnement d'un actionneur capacitif (PI) qui est connecté à une borne de sortie (A) d'un dispositif, constitué d'un premier condensateur (C1) disposé entre une borne d'entrée (E) du dispositif et un potentiel de référence (GND), d'un premier circuit en série connecté en parallèle avec celui-ci d'un premier et d'un deuxième élément de commutation de puissance (T1, T2), d'une première bobine (L1) dont la première borne est connectée à la prise médiane de la première connexion en série et dont la deuxième borne est connectée par l'intermédiaire d'un troisième élément de commutation de puissance (T3) au potentiel de référence (GND) et par l'intermédiaire d'un quatrième élément de commutation de puissance (T4) à la borne de sortie (A),
dans lequel les éléments de commutation de puissance (T1-T4) sont des diodes (D1-D4) connectées en parallèle de manière à ce qu'elles soient polarisées en sens bloquant de la borne d'entrée (E) ou de la borne de sortie (A) vers le potentiel de référence (GND),
**caractérisé en ce que**,
pour charger l'actionneur capacitif (PI), les premier et troisième éléments de commutation de puissance (T1, T3) sont initialement rendus passants par un circuit de commande (Control) de manière à ce qu'un courant puisse passer depuis le premier condensateur (C1) par l'intermédiaire de la première bobine (L1), cela ayant pour effet de stoker de l'énergie dans la bobine (L1), lorsqu'une valeur de courant maximale prédéterminée est atteinte, les premier et troisième éléments de commutation de puissance (T1, T3) précédemment passants sont de nouveau rendus non passants de manière à ce que l'énergie magnétique stockée dans la première bobine (L1) soit dépensée sous la forme d'un courant passant à travers la diode (D2) du deuxième élément de commutation de puissance (T2) et la diode (D4) du quatrième élément de commutation de puissance (T4), de sorte que l'actionneur capacitif (PI) se charge à une tension correspondante, et
à ce que l'actionneur capacitif (PI) se charge à une tension prédéterminée lors d'une répétition éventuelle des commutations à l'état passant et non passant des premier et troisième éléments de commutation de puissance (T1, T3).

2. Procédé selon la revendication 1, **caractérisé en ce que** les deuxième et quatrième éléments de commutation de puissance (T2, T4) sont rendus passants par le circuit de commande (Control) pour décharger l'actionneur capacitif (PI) de manière à ce qu'un courant passe de l'actionneur capacitif (PI) vers le potentiel de référence (GND) par l'intermédiaire de la première bobine (L1).
